# EUROPÄISCHE PATENTSCHRIFT

(11) **EP 3 811 347 B1**
(45) Veröffentlichungstag und Bekanntmachung des Hinweises auf die Patenterteilung: **03.08.2022**
(21) Anmeldenummer: 19732010.4
(22) Anmeldetag: 19.06.2019
(51) Int. Cl.: G08B 21/02, H02H 5/12

(54) **ANORDNUNG UND VERFAHREN ZUR ERHÖHUNG DER SICHERHEIT EINER PERSON IM FALLE EINES STROMUNFALLS**
ASSEMBLY AND METHOD FOR INCREASING THE SAFETY OF A PERSON IN THE EVENT OF AN ELECTRICAL ACCIDENT
AGENCEMENT ET PROCÉDÉ POUR RENFORCER LA SÉCURITÉ D'UNE PERSONNE EN CAS D'ACCIDENT ÉLECTRIQUE

(30) Priorität: 21.06.2018 AT 505122018
(43) Veröffentlichungstag der Anmeldung: 28.04.2021
(73) Patentinhaber: Adaptive Regelsysteme Gesellschaft mbH, 5020 Salzburg (AT)
(72) Erfinder: KLAPPER, Ulrich, 6830 Rankweil (AT)
(74) Vertreter: Patentanwälte Pinter & Weiss OG
(86) Internationale Anmeldenummer: PCT/EP2019/066119
(87) Internationale Veröffentlichungsnummer: WO 2019/243382

(56) Entgegenhaltungen:
- WO-A1-2017/079389
- DE-A1- 4 219 894
- DE-A1- 10 261 344
- DE-C2- 4 219 894
- US-A1- 2003 011 484

## Beschreibung

Die gegenständliche Erfindung betrifft eine Anordnung mit erhöhter Sicherheit, und ein zugehöriges Verfahren, für eine an einer elektrischen Anlage arbeitende Person bei einem Stromunfall, wobei die Person eine Schutzvorrichtung zum Erkennen eines elektrischen Körperstroms durch die Person trägt und sich im Umfeld der verunfallten Person zumindest eine weitere Person mit einer Schutzvorrichtung oder einem externen Kommunikationsgerät befindet.

Elektrische Anlagen zur Energieversorgung, Verteilung und Übertragung von elektrischer Energie, wie beispielsweise eine Energieversorgung in einem Gebäude oder für einen Maschinenpark oder ein elektrisches Hochspannungsnetz oder Abschnitte davon, bedürfen einer regelmäßigen Überprüfung, Wartung und Instandhaltung, die von entsprechenden Personen durchgeführt wird, zum Teil auch während des laufenden Betriebs. Dabei bedient man sich oftmals auch spezieller Prüfgeräte, die mit Teilen des Energieübertragungssystems verbunden werden. Solche Prüfgeräte können für eine Überprüfung selbst hohe elektrische Spannungen und/oder Ströme erzeugen. Damit geht in diesem Zusammenhang eine immanente Gefährdung solcher Personen einher, da im Falle eines unbeabsichtigten Kontaktes mit stromführenden oder unter Spannung stehenden Teilen durch Stromschlag Lebensgefahr oder zumindest die Gefahr von teils erheblichen Verletzungen bestehen kann. Im Umfeld einer elektrischen Anlage befinden sich in der Regel auch Personen, die im Falle eines falschen Verhaltens oder eines Fehlers in der elektrischen Anlage, beispielsweise ein Isolationsbruch, bei Berührung eines unter Spannung stehenden Bauteils ebenfalls einen Stromschlag erleiden können. Es ist daher üblich an elektrischen Anlagen, insbesondere im industriellen Umfeld, einen Notaus vorzusehen, um im Falle der Berührung eines unter Spannung stehenden oder stromführenden Bauteils durch eine Person den Bauteil spannungsfrei zu schalten. Mit solchen Sicherheitsvorrichtungen kann die Sicherheit von an unter Spannung stehenden Teilen oder stromführenden Teilen arbeitenden Personen vor Stromschlag durch unbeabsichtigten Kontakt erhöht werden, indem weitere anwesende Personen den Notaus im Fehlerfall auslösen. Das bedingt aber, dass sich zumindest eine weitere Person in der Nähe eines Stromunfalles aufhält und auch Kenntnis vom Stromunfalle erlangt, was aber nicht immer der Fall ist.

Es sind daher schon Verfahren und Geräte zum besseren Schutz von Personen gegen unzulässige elektrische Körperströme bekannt geworden. Die DE 39 03 025 A1 beschreibt beispielsweise ein solches Verfahren und eine solche Einrichtung, wobei an zumindest zwei Extremitäten der Person, z.B. Armen oder Beinen, jeweils eine Elektrode angeordnet ist, die mit einem Steuergerät verbunden sind. Über die Elektroden wird durch das Steuergerät ein Körperstrom durch Kontakt eines elektrischen Fremdpotentials erfasst. Wird ein solcher Stromfluss erkannt, so aktiviert das Steuergerät eine Abschalteinrichtung, mit der die weitere Stromzufuhr in die Kontaktstelle unterbrochen wird. Die Elektroden und das Steuergerät können dabei an einem Kleidungsstück angeordnet sein und die Verbindung zwischen Steuergerät und Abschalteinrichtung ist kabellos ausgeführt. Eine ähnliche Schutzvorrichtung zeigt die DE 44 38 063 A1. Mit solchen Schutzvorrichtungen kann die Sicherheit von an unter Spannung stehenden Teilen oder stromführenden Teilen arbeitenden Personen vor Stromschlag durch unbeabsichtigten Kontakt erhöht werden.

Weiterhin ist es aus der DE 42 19 894 A1 bekannt, eine andere Person über eine Kommunikationsverbindung von einem Unfall zu informieren

Es ist daher die Aufgabe der gegenständlichen Erfindung die Sicherheit für Personen im Bereich einer elektrischen Anlage gegen Stromschläge bei Berührung von stromführenden oder unter Spannung stehenden Teilen der elektrischen Anlage zu erhöhen.

Diese Aufgabe wird erfindungsgemäß dadurch gelöst, dass an der Schutzvorrichtung der verunfallten Person eine Kommunikationseinheit vorgesehen ist, die Schutzvorrichtung der verunfallten Person zumindest im Falle eines Stromunfalles mit einem mit der Schutzvorrichtung detektierten unzulässigen Körperstrom eine Kommunikationsverbindung zwischen der Kommunikationseinheit der Schutzvorrichtung der verunfallten Person und der Schutzvorrichtung der weiteren Person oder zwischen der Kommunikationseinheit der Schutzvorrichtung der verunfallten Person und dem externen Kommunikationsgerät der weiteren Person aufbaut und die Schutzvorrichtung der verunfallten Person die zumindest eine weitere Person über die Kommunikationsverbindung vom Stromunfall informiert. Damit kann sichergestellt werden, dass zumindest eine weitere Person im Umfeld der verunfallten Person über einen allfälligen Stromunfall informiert wird. Diese weitere Person kann dann eine effiziente Handlung zur Rettung der verunfallten Person oder der Schutz anderer Personen im Umfeld, beispielsweise durch Ausschalten oder Kurzschließen eines Stromkreises oder auch durch Wegrempeln der verunfallten Person, setzen. Insbesondere bei Stromschlägen kann eine schnelle Hilfe lebensrettend sein, was durch die gegenständliche Erfindung ermöglicht wird.

Gleichzeitig kann damit auch die Sicherheit weiterer Personen gegen mögliche Stromschläge erhöht werden, weil diese unmittelbar über einen Stromumfall im Umfeld informiert werden. Weitere vorteilhafte Ausgestaltungen und Wirkungen der Erfindung ergeben sich aus den abhängigen Ansprüchen und der nachfolgenden Beschreibung.

Die gegenständliche Erfindung wird nachfolgend unter Bezugnahme auf die Figuren 1 bis 8 näher erläutert, die beispielhaft, schematisch und nicht einschränkend vorteilhafte Ausgestaltungen der Erfindung zeigen. Dabei zeigt
Fig.1 eine für die Erfindung verwendete Schutzvorrichtung,
Fig.2 die Einbindung eines Notsignaleingangs zum Empfangen eines Notsignals in einem Gerät,
Fig.3 ein Ausführungsbeispiel des erfindungsgemäßen Verfahrens zum Verständigen einer weiterer Person im Umfeld einer durch einen Stromunfall verunfallten Person, die eine Schutzvorrichtung trägt,
Fig.4 die Verwendung externer Kommunikationsgeräte für die Herstellung einer Kommunikationsverbindung,
Fig.5 die Alarmierung eines Stromunfalls an eine entfernte Stelle,
Fig.6 die Alarmierung der entfernten Stelle über ein mobiles Endgerät,
Fig.7 die Erfassung der Position der Person mit Schutzvorrichtung und
Fig.8 eine Anordnung mit mehreren Funkempfängern zum Übertragen des Notsignals von einer Schutzvorrichtung.

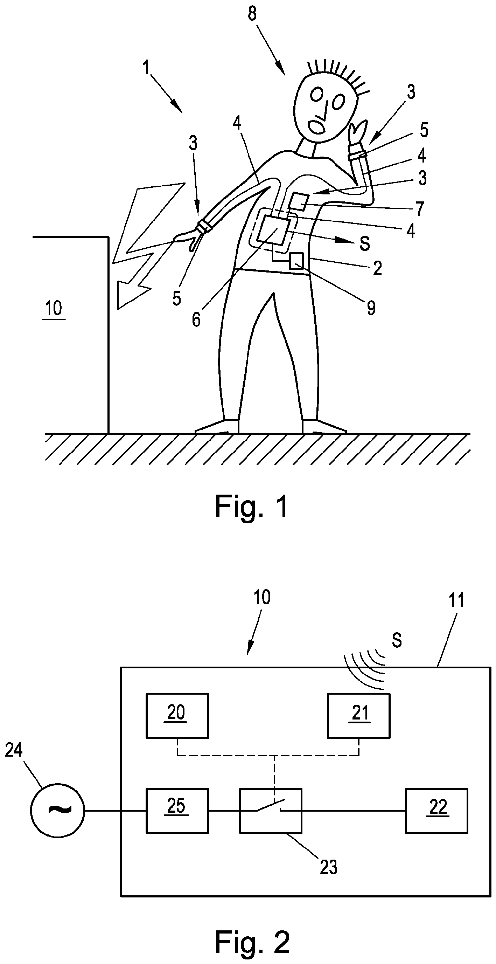

Die gegenständliche Erfindung nutzt eine Schutzvorrichtung 1, die in ihrer grundlegenden Funktion aus dem Stand der Technik bekannt ist, und die mit Bezugnahme auf die Fig.1 zum besseren Verständnis näher erläutert wird. Die Schutzvorrichtung 1, oder zumindest Teile davon, ist an einem Bekleidungsstück 2, hier ein Hemd, angeordnet oder integriert. Selbstverständlich kommen als Bekleidungsstück 2 auch andere Teile in Frage, z.B. eine Hose, ein Pullover, ein T-Shirt, eine Jacke, ein Overall, usw. Auch Kombinationen mehrerer Teile kommen als Bekleidungsstück 2 in Frage, z.B. eine Kombination aus Hose und Hemd, usw. Am Bekleidungsstück 2 ist zumindest ein Sensor 3 angeordnet, um einen durch den menschlichen Körper fließenden elektrischen Körperstrom zu detektieren. Als Sensor 3 kommen beispielsweise Elektroden 5 in Frage, um ein elektrisches Potential oder einen elektrischen Strom zu erfassen. Die Elektroden 5 sind vorzugsweise an exponierten Stellen des Bekleidungsstückes 2 angeordnet, beispielsweise im Bereich von Extremitäten, also beispielsweise an Ärmeln, Hosenbeinen oder Kapuzen. Als Sensor 3 kommt auch ein biometrischer Sensor 7 in Frage, um ein biometrisches Signal, beispielsweise die Frequenz des Herzschlages, die Amplitude oder den Verlauf des Herzschlages, die Atemfrequenz, den Hautwiderstand, usw., zu erfassen. Durch Auswertung des biometrischen Signals, insbesondere des Herzschlages (Frequenz, Amplitude und/oder Verlauf), kann ebenfalls auf einen fließenden elektrischen Körperstrom geschlossen werden.

Der Sensor 3, oder die Sensoren, kann dazu vorzugsweise im Bekleidungsstück 2 integriert sein, kann aber auch separat angelegt werden, beispielsweise mittels einer Manschette, eines Armbands oder eines Gurtes. In einer möglichen Ausführung könnte ein Sensor 3 als Elektrode 5 in Form einer bekannten Rogowski Spule ausgeführt sein (wie in Fig.1), um einen durch eine Extremität, oder anderen Teil des menschlichen Körpers, fließenden elektrischen Strom zu erfassen. Dazu kann die Elektrode 5 ringförmig um eine Extremität gelegt sein, z.B. in einem Bund eines Ärmels oder eines Hosenbeins des Bekleidungsstückes 2. Für die Erfassung eines elektrischen Potentials muss die Elektrode 5 elektrisch leitend an der Haut anliegen, während das z.B. im Falle einer Rogowski Spule nicht unbedingt erforderlich wäre. Es kann auch zwischen zwei Elektroden 5 regelmäßig oder ständig eine Widerstandsmessung erfolgen, um zu prüfen ob das Kleidungsstück 2 ordnungsgemäß mit dem Körper der Person 8 verbunden ist. Um den Herzschlag zu erfassen könnte im Bekleidungsstück 2 ein entsprechender biometrischer Sensor 7, z.B. ein Herzfrequenzsensor, im Bekleidungsstück 2 im Bereich der Brust integriert sein, oder es könnte ein entsprechender Brustgurt angelegt werden.

Ein Sensor 3 ist über zumindest eine Signalleitungen 4 mit einer Auswerteeinheit 6 (beispielsweise in Form einer Recheneinheit, gegebenenfalls auch mit entsprechender Software) verbunden. In der Auswerteeinheit 6 werden die mit dem zumindest einen Sensor 3 erfassten Signale ausgewertet. Beispielsweise kann ein mit einer Elektrode 5 als Sensor 3 erfasstes elektrisches Potential oder ein erfasster fließender elektrischer Strom ausgewertet werden. Zwischen zwei erfassten elektrischen Potentialen, beispielsweise mit zwei als Elektroden 5 ausgeführten Sensoren 3, kann eine anliegende elektrische Spannung ermittelt und in der Auswerteeinheit 6 ausgewertet werden. Die Auswertung kann analog mit geeigneter Hardware oder digital, was eine A/D-Wandlung und entsprechende Hardware und Software erforderlich macht, erfolgen. Die Auswerteeinheit 6 erzeugt im Falle eines erkannten gefährlichen Körperstromes, beispielsweise bei einem abnormalen Herzschlag, einem erfassten gefährlichen Stromfluss oder einer gefährlichen Potentialdifferenz (Spannung) zwischen zwei Elektroden 5, was wiederum auf einen Stromfluss durch den Körper schließen lässt, ein Notsignal S, das genutzt werden kann, um eine gewünschte Aktion auszulösen. Hierzu können in der Auswerteeinheit 6 natürlich auch entsprechende Grenzwerte für einen zulässigen Körperstrom, beispielsweise eine zulässige Potentialdifferenz oder ein zulässiger Strom, hinterlegt oder vorgegeben werden, die auch änderbar sein können. Ebenso können in der Auswerteeinheit 6 auch Muster eines biometrischen Signals hinterlegt sein, die auf einen gefährlichen Körperstrom schließen lassen.

In vorteilhafter Weise können am Bekleidungsstück 2 verschiedene Sensoren 3 vorgesehen sein, um die Sicherheit der Erkennung von gefährlichen elektrischen Körperströmen zu erhöhen. Beispielsweise könnten Elektroden 5 an Extremitäten vorgesehen sein und zusätzlich ein biometrischer Sensor 7 zur Erfassung des Herzschlages, wie in Fig.1 dargestellt.

Ebenso kann durch Vorsehen von Redundanzen die Sicherheit der Schutzvorrichtung 1 erhöht werden. Beispielsweise kann pro Sensor 3 mehr als eine Signalleitung 4 vorgesehen sein, wodurch mögliche Kabelbrüche oder Kontaktfehler nicht zum Ausfall der Sicherheitsfunktion führen müssen oder ein Kabelbruch oder Kontaktfehler sogar erkannt, und gegebenenfalls auch angezeigt, werden kann.

Die Auswerteeinheit 6 wird vorzugsweise von der Person 8, die die Schutzvorrichtung 1 trägt, gehalten oder getragen. Beispielsweise könnte diese in einer Umhängetasche oder einem Rucksack angeordnet sein, könnte aber auch in einer Tasche des Bekleidungsstückes 2 gesteckt sein oder könnte vorteilhafterweise, ganz oder teilweise, auch im Bekleidungsstück 2 integriert sein, beispielsweise in Form eines intelligenten Kleidungstückes mit integrierter Elektronik.

Das Notsignal S kann grundsätzlich kabelgebunden oder kabellos ausgegeben werden und kann am Notsignaleingang kabelgebunden oder kabellos empfangen werden.

Die Schutzvorrichtung 1 besteht somit beispielsweise aus einem Bekleidungsstück 2 mit zumindest einen Sensor 3 und einer Auswerteeinheit 6, die mit zumindest einer Signalleitung 4 mit dem zumindest einen Sensor 3 verbunden ist und die ein vom Sensor 3 erfasstes Signal auswertet, um einen gefährlichen elektrischen Körperstrom zu erfassen. Das Notsignal S der Auswerteeinheit 6, oder allgemein der Schutzvorrichtung 1, kann in der elektrischen Anlage 10 genutzt werden, um bestimmte konfigurierte Handlungen zu setzen, um die Sicherheit einer Person 8 gegen Stromschlag zu erhöhen. Solche Handlungensind insbesondere Schalthandlungen, um die elektrische Anlage 10, oder Teile davon, spannungsfrei zu schalten.

Beispielhaft sei das mit Bezugnahme auf die Fig.2 erläutert, die ein Gerät 11 als Beispiel einer elektrischen Anlage 10 oder Teil einer elektrischen Anlage 10 zeigt. Im Gerät 11 ist ein Strom- und/oder Spannungsgenerator 25 vorgesehen, der benötigte elektrische Ströme und/oder Spannungen an den Strom- und Spannungsausgängen 22 des Geräts 11 erzeugt. Das Gerät 11 ist dazu mit einer Energieversorgung 24 verbunden, die extern sein kann (beispielsweise ein elektrisches Netz oder eine externe Batterie, oder auch intern (z.B. im Falle eines batteriebetriebenen Gerätes). Im Gerät 11 ist zwischen dem Strom- und/oder Spannungsgenerator 25 und den Strom- und Spannungsausgängen 22 eine Trenneinheit 23 vorgesehen. Die Trenneinheit 23 könnte aber auch vor dem Strom- und/oder Spannungsgenerator 25 vorgesehen sein, oder auch an einer anderen geeigneten Stelle im Gerät 11. Die Trenneinheit 23 kann dabei natürlich auch mehrpolig ausgeführt sein, je nach der Anzahl der Strom- und Spannungsausgänge 22. Der Notaus-Schalter 20 aktiviert beim Betätigen die Trenneinheit 23, beispielsweise ein Trennrelais, im Gerät 11, das die Strom- und Spannungsausgänge 22 des Geräts 11 strom- und spannungslos schaltet und/oder kurzschließt. Der Notaus-Schalter 20 kann von einer anwesenden Person, manuell betätigt werden, um die Ausgänge des Geräts 11 und/oder die elektrische Anlage 10 und/oder Teile einer elektrischen Anlage 10 strom- und spannungslos zu schalten und/oder kurzzuschließen. An der elektrischen Anlage 10 ist zusätzlich ein Notsignaleingang 21 vorgesehen, der bei Empfang eines Notsignals S, insbesondere von der Schutzvorrichtung 1, die Trenneinheit 23 des Notaus-Kreises betätigt. Erfindungsgemäß ist folglich auch der Notsignaleingang 21 mit der Trenneinheit 23 verbunden und aktiviert die Trenneinheit 23 beim Empfang eines Notsignals S über den Notsignaleingang 21. Es könnten aber natürlich im Gerät 11 gleichwirkend auch mehrere seriell geschaltete Trenneinheiten 23 vorgesehen sein, die jeweils separat angesteuert werden, beispielsweise eine Trenneinheit für den Notaus-Schalter 20 und eine Trenneinheit 23 für den Notsignaleingang 21. Der Notsignaleingang 21 muss aber nicht zwingend in das Gerät 11 integriert sein, sondern könnte auch als separate Einheit ausgeführt sein, die mit dem Gerät 11 verbunden ist.

Das spannungsfrei Schalten der elektrischen Anlage 10, oder eines Teiles davon, kann natürlich ebenso auf andere Weise realisiert werden. Beispielsweise könnte ein Schalter aktiviert werden, um einen Stromkreis vom Versorgungsnetz zu trennen. Ebenso könnte ein Stromkreis kurzgeschlossen werden (beispielsweise durch Verbinden einer Phase mit dem Nullleiter), um einen Sicherungsautomaten auszulösen, um den Stromkreis vom Netz zu trennen. Ebenso könnte ein ausreichend hoher Erdfehlerstrom erzeugt werden (beispielsweise durch Verbinden einer Phase über einen Widerstand mit Erde), um einen Fehlerstromschutzschalter auszulösen. Daneben gibt es aber natürlich auch noch andere Möglichkeiten, um die elektrische Anlage 10, oder Teile davon, spannungsfrei zuschalten.

In der Schutzvorrichtung 1, vorzugsweise am Bekleidungsstück 2 oder an einer externen Einheit, die in Datenverbindung mit der Schutzvorrichtung 1 steht, kann optional zumindest ein weiterer Sensor 9 zur Erfassung einer weiteren Größe vorgesehen sein, wobei mit der weitere Größe ein weiterer Zustand der Person 8 (neben einem möglichen Körperstrom) erfasst wird. Der weitere Sensor 9 kann beispielsweise ein Beschleunigungssensor sein, um einen Fall der Person 8 feststellen zu können. Mittels eines Lagesensors als weiterer Sensor 9 kann erkannt werden, wenn die Person 8 liegt. Der weitere Sensor 9 kann zur Aufnahme eines EKG (Elektrokardiogramm) ausgestaltet sein, das in Zusammenhang mit einem Stromunfall wichtige Information über den Zustand der verunfallten Person 8 liefern kann. Mittels eines Beschleunigungssensors oder Bewegungssensors als weiterer Sensor 9 kann auch die Atmung der verunfallten Person 8 erfasst werden. Natürlich können auch mehrere weitere Sensoren 9 an der Schutzvorrichtung 1 vorgesehen sein, wobei beliebige Kombinationen der obigen Sensoren 9 denkbar sind.

Mit dem Sensor 3, oder den Sensoren 3, erfasste Werte und/oder mit dem zumindest einen weiteren Sensor 9 erfasste Werte können in der Schutzvorrichtung 1 in einer Speichereinheit, beispielsweise in der Auswerteeinheit 6, auch gespeichert werden. Das ermöglicht es gespeicherte Werte zu einem späteren Zeitpunkt auszulesen oder auch an andere Stellen zu übertragen.

Wird ein Kontakt der Person 8 mit einem stromführenden oder unter Spannung stehenden Teil einer elektrischen Anlage 10, was einen durch die Person 8 fließenden unzulässigen Körperstrom verursacht, durch die Schutzvorrichtung 1 wie oben beschrieben detektiert, wird ein Notsignal S ausgelöst, beispielsweise kabellos, beispielsweise über eine Funkverbindung. Die Schutzvorrichtung 1 löst damit über den Notsignaleingang 21 an der elektrischen Anlage 10 eine Schalthandlung aus, die darauf abzielt, zumindest den Teil, der von einer Person 8 berührt wird, spannungsfrei zu schalten.

In vielen Situationen kann die Schutzvorrichtung 1 über einen Notsignaleingang 21 erfolgreich einen Notaus betätigen oder eine andere Schalthandlung veranlassen und damit die elektrische Anlage 10 oder zumindest Teile davon strom- und spannungslos schalten. Wenn die Schutzvorrichtung 1 aktiviert wird, ist es in diesen Situationen aber bereits zu einem Stromschlag gekommen.

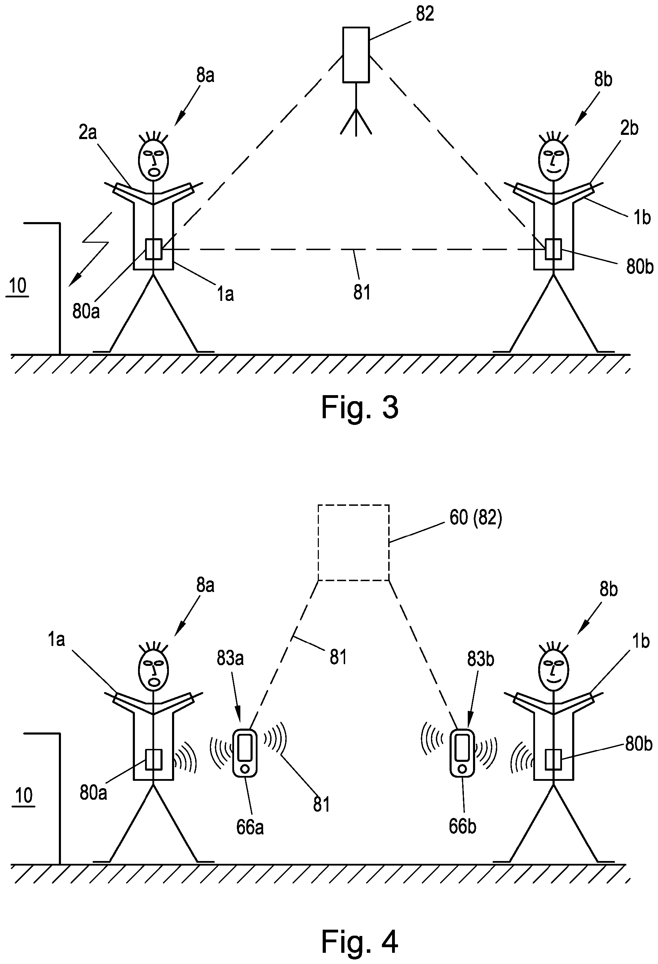

In vielen Fällen werden sich zur Durchführung von Arbeiten an stromführenden Teilen einer elektrischen Anlage 10 gleichzeitig mehrere Personen im Bereich der Arbeiten aufhalten. Typische Beispiele sind ein Unfall mit einem Elektrofahrzeug oder allgemein ein Stromunfall, an dem mehrere Feuerwehrleute oder Rettungsleute arbeiten, oder Arbeiten an herunterhängenden Stromleitungen oder umgestürzten Strommasten nach einem Sturm. In solchen Situationen kann es aber vorkommen, dass ein Stromunfall einer Person 8 von anderen Personen im Umfeld, auch in unmittelbarer Nähe, nicht wahrgenommen wird. Dadurch können auch andere Personen in Gefahr kommen, beispielsweise, weil sie die im Stromkreis befindliche Person 8 berühren oder weil sie auch den unter Spannung stehenden Teil berühren. Abgesehen davon ist eine effiziente Handlung zur Rettung der verunfallten Person 8 oder der Schutz anderer Personen im Umfeld, beispielsweise durch Ausschalten oder Kurzschließen des Stromkreises oder auch durch Wegrempeln der verunfallten Person 8, nur dann möglich, wenn zumindest eine andere Person im Umkreis Kenntnis vom Stromunfall erlangt. In solchen Fällen kann eine erfindungsgemäße Schutzvorrichtung 1 vorteilhaft eingesetzt werden, wie anhand der Fig.3 beispielhaft beschrieben wird.

Es wird dabei davon ausgegangen, dass sich mehrere Personen 8a, 8b mit jeweils einer Schutzvorrichtung 1a, 1b im Umfeld eines unter Spannung stehenden Bauteils einer elektrischen Anlage 10 befinden und dass die Schutzvorrichtungen 1a, 1b in Kommunikationsverbindung 81 stehen. Dazu kann jede Schutzvorrichtung 1a, 1b mit einer Kommunikationseinheit 80a, 80b ausgeführt sein, um eine Kommunikationsverbindung 81, beispielsweise Bluetooth, aufbauen zu können. Eine Kommunikationseinheiten 80a, 80b kann im Bekleidungsstück 2 integriert sein, beispielsweise wieder als Teil einer intelligenten Kleidung, kann aber auch als separate Komponente (Hardware) in der Schutzvorrichtung 1a, 1b vorgesehen sein. Die Kommunikationsverbindung 81 kann permanent aufgebaut sein, oder kann auch anlassbezogen aufgebaut werden. Erkennt eine Schutzvorrichtung 1a einer Person 8a einen unzulässigen Körperstrom durch die Person 8a, weil diese Person 8a z.B. in einen Stromkreis gerät, so wird über die Kommunikationseinheit 80a der von der Person 8a getragenen Schutzvorrichtung 1a die zumindest eine weitere Person 8b im Umkreis über die Kommunikationsverbindung 81 und die Kommunikationseinheit 80b der von der weiteren Person 8b getragenen Schutzvorrichtung 1b darüber informiert. Die konkrete Art der Alarmierung oder Datenübermittlung spielt hier keine Rolle, wichtig ist nur, dass die weitere Person 8b von der Schutzvorrichtung 1a der verunfallten Person 8a alarmiert wird und damit in die Lage versetzt wird, eine entsprechende Handlung zur Hilfe der verunfallten Person 8a zu setzen. Das erhöht die Sicherheit der verunfallten Person 8a, da im Falle eines Stromunfalls schneller Hilfe geleistet werden kann. Vor allem die schnelle und zielgerichtete Hilfe kann bei Stromunfällen für die verunfallte Person 8a entscheidend sein.

Dazu kann an einer Schutzvorrichtung 1a, 1b auch eine entsprechende Signalisierungseinheit, beispielsweise ein akustischer, visueller oder palpabler Alarm, vorgesehen sein. Wenn eine Schutzvorrichtung 1a, 1b zusätzlich mit einer eindeutigen Kennung versehen ist, kann zusätzlich auch noch übermittelt werden, welche Schutzvorrichtung 1a betroffen ist, um die verunfallte Person 8a leichter ausfindig machen zu können. Es könnte aber auch an der Schutzvorrichtung 1a der verunfallten Person 8a eine visuelle oder akustische Signalisierung gestartet werden, um anderen Personen 8b rasch zu ermöglichen, zu erkennen, welche im Umfeld befindliche Person 8a verunfallt ist. Damit kann die Hilfe für eine verunfallte Person 8a erheblich beschleunigt werden.

Die Kommunikationseinheiten 80a, 80b der beiden Schutzvorrichtungen 1a, 1b müssen aber nicht direkt miteinander kommunizieren. Denkbar wäre es beispielsweise, dass im Bereich der Arbeiten eine Kommunikationszentrale 82 aufgestellt wird, mit der sich die einzelnen Schutzvorrichtungen 1a, 1b über deren Kommunikationseinheiten 80a, 80b verbinden, wie in Fig.3 angedeutet. Die Kommunikationsverbindung 81 wird dann über die Kommunikationszentrale 82 hergestellt. Die Kommunikationszentrale 82 sorgt dann dafür, dass eine Alarmierung von einer Schutzvorrichtung 1a an alle anderen bekannten Schutzvorrichtungen 1b übermittelt wird. Dabei kann vorgesehen sein, dass sich die Schutzvorrichtungen 1 im Umfeld der Kommunikationszentrale 82 (innerhalb des Empfangs- und Sendebereichs) an der Kommunikationszentrale 82 anmelden, damit diese Kenntnis über alle im Umkreis vorhandenen Schutzvorrichtung 1 erhält. Alternativ könnte die Kommunikationszentrale 82 auch einfach eine Alarmierung absenden (z.B. in Form einer Broadcast Nachricht), die von allen im Empfangsbereich befindlichen Schutzvorrichtung 1 empfangen werden kann.

Ebenso ist es denkbar, dass sich die Kommunikationseinheiten 80a der Schutzvorrichtung 1a der verunfallten Person 8a mit einem externen Kommunikationsgerät 83a der Person 1a, beispielsweise ein mobiles Endgerät 66a, verbindet (beispielsweise über Bluetooth), das dann die Kommunikationsverbindung 81 zur weiteren Person 8b herstellt, wie in Fig.4 dargestellt. In diesem Fall wird eine Kommunikationsverbindung 81 zu einem externen Kommunikationsgerät 83b der weiteren Person 8b, beispielsweise ein mobiles Endgerät 66b der Person 8b hergestellt, um die weitere Person 8b zu alarmieren. Zusätzlich könnte das externe Kommunikationsgerät 83b der weiteren Person 8b auch mit einer Kommunikationseinheit 80b der Schutzvorrichtung 1b der weiteren Person 8b verbunden sein (beispielsweise über Bluetooth), die wiederum optional auch eine Signalisierung an der Schutzvorrichtung 1b auslösen kann.

Es könnte auch vorgesehen sein, dass die Schutzvorrichtung 1b der alarmierten Person 8b bei einer Alarmierung selbst wieder ein Notsignal S ausgibt, das dann wiederum für eine Schalthandlung in der elektrischen Anlage 10 genutzt werden kann.

Statt einer aufgestellten Kommunikationszentrale 82 im Umfeld der Personen 8a, 8b könnte die beschriebene Kommunikationsverbindung 81 aber auch über eine weit entfernte Stelle 60 als Kommunikationszentrale 82 erfolgen, wie in Fig.4 angedeutet. Das ist insbesondere dann interessant, wenn als externe Kommunikationsgeräte 83a, 83b mobile Endgeräte 66a, 66b verwendet werden, die eine Kommunikationsverbindung 81 über eine weite Distanz ermöglichen.

Die Alarmierung einer weiteren Person 8b mit einer Schutzvorrichtung 1b, die in Kommunikationsverbindung 81 mit der Schutzvorrichtung 1a der verunfallten Person 8a steht, ist unabhängig davon, ob an der Schutzvorrichtung 1a der verunfallten Person 8a ein Notsignal S ausgegeben wird oder ob im Falle der Ausgabe des Notsignals S auch eine Schalthandlung gesetzt wird, die die elektrische Anlage 10, oder einen Teil davon, spannungsfrei schaltet. Die Sicherheit der verunfallten Person 8b wird schon alleine dadurch erhöht, dass zumindest eine weitere Person 8b im Umfeld von einem Stromunfall informiert wird und diese weitere Person 8b dann eine effiziente Handlung zur Rettung der verunfallten Person 8a oder zum Schutz anderer Personen im Umfeld, beispielsweise durch Ausschalten oder Kurzschließen eines Stromkreises oder auch durch Wegrempeln der verunfallten Person 8a setzen kann. Das gilt auch für den Fall, dass die Schutzvorrichtung 1a zwar ein Notsignal S ausgibt, das eine Schalthandlung auslösen soll, aber die Schalthandlung aus welchen Gründen auch immer erfolglos bleibt. Auch in diesem Fall ist die Alarmierung einer weiteren Person 8b im Umfeld ein wichtiger Schritt zur Erhöhung der Sicherheit.

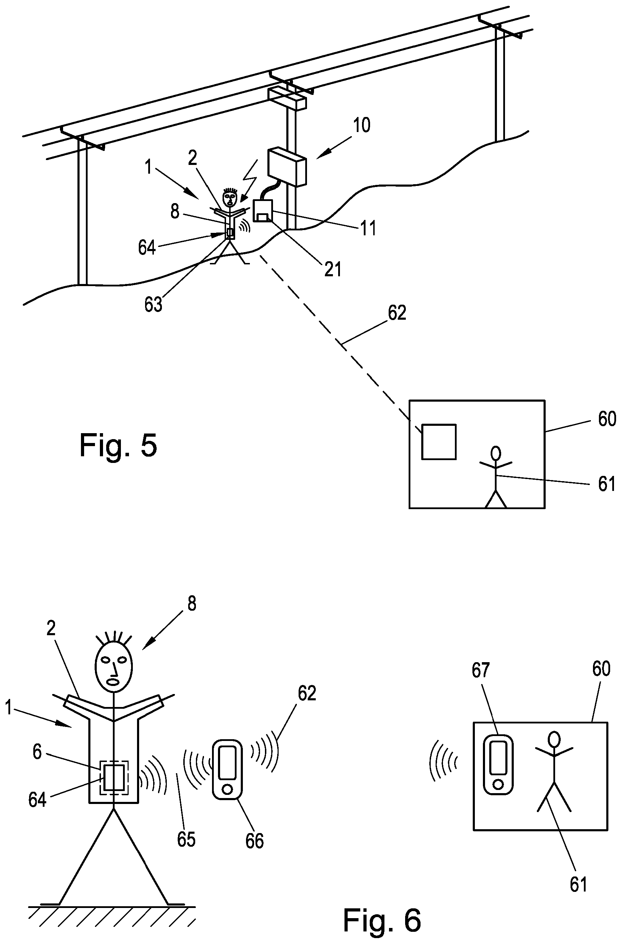

Um die Sicherheit für die verunfallte Person 8a noch weiter zu erhöhen, kann vorgesehen sein, dass eine Schutzvorrichtung 1 zusätzlich mit einer Sendeeinheit 64, wie z.B. ein Mobilfunksender 63, auch eine Funkverbindung 62 (angedeutet durch strichlierte Linie) zu einer konfigurierten, vom Ort des Stromunfalls entfernten Stelle 60 aufbaut, sodass Hilfe für die verunfallte Person 8 veranlasst oder koordiniert wird, vorzugsweise von einer weiteren Person 61 in der entfernten Stelle 60, wie in Fig.5 dargestellt. Nachdem beide Schutzvorrichtungen 1a, 1b Kenntnis über den Stromunfall haben, ist es an sich unerheblich, welche der beteiligten Schutzvorrichtungen 1a, 1b die Funkverbindung 62 aufbaut, weshalb im weiteren diesbezüglich nicht mehr unterschieden wird. Vorzugsweise erfolgt die Information der entfernten Stelle 60 aber über die Schutzvorrichtung 1 der verunfallten Person 8. "Entfernt" bedeutet in diesem Zusammenhang, dass diese weitere Person 61 zumindest so weit von der verunfallten Person 8 entfernt ist, dass diese weitere Person 61 den Zustand der verunfallten Person weder visuell noch akustisch unmittelbar wahrnehmen kann. Die weitere Person 61 kann beispielsweise in einer Notfallzentrale sitzen, die an einem gänzlich anderen Ort sein kann. Eine solche entfernte Stelle 60 kann auch als Kommunikationszentrale 82 wie oben beschrieben fungieren. Die Schutzvorrichtung 1 kann die Funkverbindung 62 über die Sendeeinheit 64 direkt aufbauen, beispielsweise mittels eines Mobilfunksenders 63, der im Bekleidungsstück 2 integriert ist, beispielsweise wieder als Teil einer intelligenten Kleidung. Alternativ kann die Schutzvorrichtung 1 die Funkverbindung 62 auch indirekt aufbauen, beispielsweise indem sich die Schutzvorrichtung 1 über die Sendeeinheit 64 über eine geeigneten Datenverbindung 65, beispielsweise Bluetooth, mit einem mobilen Endgerät 66 der Person 8, beispielsweise ein Smartphone, verbindet (z.B. mittels Bluetooth), das dann die Funkverbindung 62 zur entfernten Stelle 60 aufbaut, wie in Fig.6 dargestellt. Über die Funkverbindung 62 kann eine vorgegebene Nachricht gesendet werden, beispielsweise eine Textnachricht (SMS), eine Datenübermittlung (beispielsweise per E-Mail) oder ein Anruf getätigt werden. Die weitere Person 61 in der entfernten Stelle 60 kann dabei ebenfalls ein mobiles Endgerät 67 bei sich tragen, das bei Bedarf mit der Funkverbindung 62 verbunden werden kann, beispielsweise über ein Mobilfunknetz. Es ist offensichtlich, dass die entfernte Stelle 60 (z.B. Notfallzentrale) nicht ortsgebunden sein muss, insbesondere, wenn die weitere Person 61 ebenfalls ein mobiles Endgerät 67 zur Kontaktierung verwendet.

Die Sendeeinheit 64, z.B. in Form eine Mobilfunksender 63, ist vorzugsweise in der Auswerteeinheit 6 oder auch im Bekleidungsstück 2 (beispielswiese in Form einer intelligenten Kleidung) selbst integriert. Die Sendeeinheit 64 kann von der Auswerteinheit 6 der Schutzvorrichtung 1 gesteuert sein.

Die weitere Person 61 kann dann Hilfe für die verunfallte Person 8 koordinieren. Beispielsweise kann in einer Notfallzentrale der Einsatzort von Personen 8, die an stromführenden oder unter Spannung stehenden elektrischen Anlagen 10 arbeiten, bekannt sein. Beispielsweise sind Wartungsarbeiten an einem Energieversorgungsnetz als elektrische Anlage 10 (wie in Fig.3) geplant und es ist bekannt, wann und wo diese durchgeführt werden. Die Schutzvorrichtung 1 kann einer bestimmten Person 8 zugeordnet sein und kann auch eine eindeutige Identifikation aufweisen (beispielsweise eine Mobilfunknummer). Damit kann in der Notfallzentrale ein eingehender Notruf (auch als Textnachricht oder als E-Mail) von einer Schutzvorrichtung 1 einem Ort und/oder eine Person 8 zugeordnet werden, womit die Hilfe durch einen Helfer von der weiteren Person 61 gezielt koordiniert werden kann.

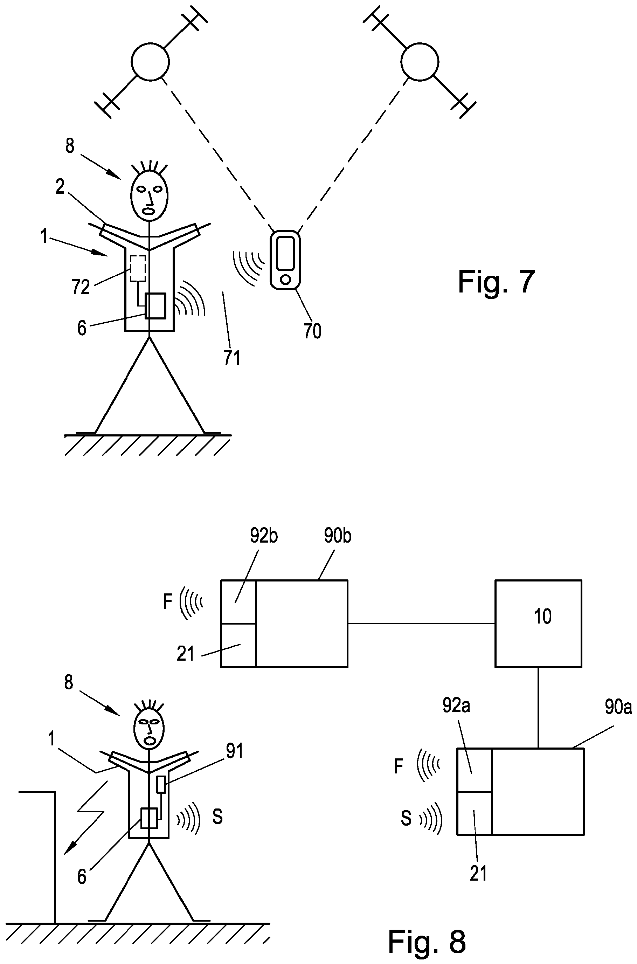

Die Schutzvorrichtung 1 kann auch mit einer Einheit 72 zur Positionsbestimmung ausgestattet sein. Dazu kann beispielsweise die Einheit 72 zur Positionsbestimmung, beispielsweise ein GPS (Global Positioning System) Sensor, am Bekleidungsstück 2 angeordnet werden (wie in Fig.7 strichliert angedeutet), oder in dieses integriert werden, beispielsweise in einer intelligenten Kleidung mit integrierter Elektronik. Selbstverständlich kommen dafür auch andere Satellitennavigationssysteme in Frage, wie beispielsweise GALILEO. Es gibt aber natürlich auch andere Möglichkeiten, die Position einer Person 8 mittels einer Einheit 72 zur Positionsbestimmung zu bestimmen. Beispielsweise könnte aus der Verfügbarkeit von WLAN (Wireless LAN) Netzen ein Rückschluss auf die aktuelle Position gezogen werden. Auch über ein Mobilfunknetz könnte eine Positionsbestimmung erfolgen, beispielsweise mittels GSM-Ortung.

Die Schutzvorrichtung 1 kann aber auch mit einer externen Einheit 71, welches eine Positionsbestimmung durchführen kann, als Einheit 72 zur Positionsbestimmung verbunden sein, wie beispielsweise in Fig.7 dargestellt. Heutige Mobiltelefone oder Smart Phones haben in der Regel eine Positionsbestimmung integriert, sodass sich hierfür besonders vorteilhaft ein mobiles Endgerät 66 als externe Einheit 71 nutzen lässt (wie in Fig.5). Die externe Einheit 71 kann aber auch ein GPS-Empfänger sein. Damit kann die Schutzvorrichtung 1 mit der externen Einheit 71 über eine geeignete Datenverbindung 65, beispielsweise Bluetooth, verbunden werden, um von der externen Einheit 71 die aktuelle Position der Person 8 zu erhalten. Zur Verbindung könnte in der Schutzvorrichtung 1 beispielsweise wieder eine Sendeeinheit 64 vorgesehen sein. Die aktuelle Position kann in der Schutzvorrichtung 1, vorzugsweise in der Auswerteinheit 6 der Schutzvorrichtung 1, gespeichert werden, vorzugsweise mit weiteren Details eines Stromunfalls, wie beispielsweise Datum, Uhrzeit, Dauer des Körperstromes, Höhe des Stromflusses, um eine spätere Auswertung zu ermöglichen. Unter aktueller Position werden hierbei sowohl Geokoordinaten verstanden, als auch ein konkreter Ort. Nachdem viele externe Einheit 71 häufig auch eine Ortungsfunktion besitzen, kann auch direkt der Ort als aktuelle Position verwendet werden.

Selbstverständlich kann die aktuelle Position oder der aktuelle Ort auch an die entfernte Stelle 60 (wie in Fig.5 oder 6) übertragen werden, um die Koordination von Hilfe für die verunfallte Person 8 zu unterstützen. Die aktuelle Position oder der aktuelle Ort könnte auch in bestimmten Zeitabständen an die entfernte Stelle 60 übermittelt werden, um immer einen aktuelle Position oder einen aktuellen Ort der Person 8 zu kennen.

Es ist offensichtlich, dass bei der Benachrichtigung einer entfernten Stelle 60 von der Schutzvorrichtung 1 bei einem Stromunfall natürlich auch zusätzliche Information übertragen werden kann, beispielsweise Daten von weiteren Sensoren 9 an der Schutzvorrichtung 1 zum Zustand der Person 8, beispielsweise Lage der Person 8 (Fall, Person liegt), Puls, EKG, Atmung. Solche zusätzliche Information kann für die Koordination der Hilfe und den Rettungseinsatz wichtig sein.

Die entfernte Stelle 60 kann aber natürlich auch insofern automatisiert sein, dass im Falle einer eingehenden Nachricht eines Stromunfalls einer Person 8 automatisiert gewisse Handlungen gesetzt werden, beispielsweise die Verständigung eines Rettungsdienstes oder Helfers, eventuell auch mit der bestimmten Position oder den Ort der Person 8, eventuell auch mit weiteren vorhandenen Daten. In diesem Fall wäre die weitere Person 61 nicht unbedingt erforderlich.

Dazu könnte die entfernte Stelle 60 auch einen, oder auch mehrere, Helfer in der Nähe der verunfallten Person 8 ermitteln und diesen gezielt über den Stromunfall informieren. Vorzugswiese wird der Helfer ermittelt, der der verunfallten Person 8 örtlich am nächsten ist. Dazu kann der Helfer mit einer Kommunikationseinheit, beispielsweise ein Mobiltelefon oder Smart Phone, ausgestattet sein, die von der entfernten Stelle 60 oder von einer weiteren Person 61 in der entfernten Stelle 60 mit einer entsprechenden Nachricht kontaktiert wird. Die Nachricht könnte eine SMS, E-Mail, oder ähnliches sein, oder auch ein Anruf.

Ein Helfer in der Nähe der verunfallten Person könnte dadurch ermittelt werden, dass in der entfernten Stelle 60 die Positionen aller in Frage kommenden Helfer bekannt sind. Beispielsweise könnten der entfernten Stelle 60 über die Kommunikationseinheiten der Helfer in vorgegebenen Abständen laufend die aktuellen Positionen übermittelt werden. Eine Nähe könnte aber auch so bestimmt werden, dass festgestellt wird, ob eine Kommunikationseinheit der verunfallten Person 8, beispielsweise ein mobiles Endgerät 66, mit einer Kommunikationseinheit eines Helfers Nachrichten austauschen können, beispielsweise über Bluetooth, oder ob beide das gleiche WLAN-Netz empfangen können. Das könnte der entfernten Stelle 60 auch von der jeweiligen Kommunikationseinheit laufend mitgeteilt werden, damit die entfernte Stelle 60 immer einen aktuellen Status hat.

Es sind Situationen denkbar, dass durch das Notsignal S eine Schalthandlung an der elektrischen Anlage 10 zwar ausgeführt wird, aber diese nicht zum gewünschten Erfolg, also Spannungsfreiheit des kontaktierten Teils, führt. Das kann beispielsweise passieren, wenn zwar ein Notstromkreis unterbrochen wird, aber ein weiterer Stromkreis vorhanden ist, der nicht am Notaus hängt. Daher kann im Gerät 11, das über den Notsignaleingang 21 das Notsignal S empfängt und eine Schalthandlung auslöst, oder in der elektrischen Anlage 10 auch überwacht werden, ob die Schalthandlung innerhalb einer vorgegebenen Zeitspanne, beispielsweise 100ms, zum gewünschten Erfolg führt, nämlich Feststellung der Spannungsfreiheit wenn nach der Schalthandlung kein Notsignal S mehr von der Schutzvorrichtung 1 empfangen wird. Kann in der festgelegten Zeitspanne keine Spannungsfreiheit festgestellt werden, kann in der elektrischen Anlage 10, z.B. über den Notsignaleingang 21, eine weitere Schalthandlung ausgelöst werden, beispielsweise um zumindest einen weiteren Stromkreis wegzuschalten. Oftmals ist es beispielsweise so, dass nur gewisse Steckdosen oder Stromversorgungen an einem Notstromkreis hängen, andere elektrische Teile aber in einem anderen Stromkreis. Damit könnte zuerst wie beschrieben der Notstromkreis getrennt werden und in einem zweiten Schritt, wenn der erste Schritt erfolglos blieb, ein definierter weiterer Stromkreis. Dabei können natürlich verschiedene Hierarchien von Stromkreisen definiert sein, die nacheinander weggeschaltet werden. Beispielsweise könnte zuerst ein Notstromkreis weggeschaltet werden, dann ein benachbarter Notstromkreis oder ein Stromkreis für normale Steckdosen, dann ein Stromkreis für EDV Infrastruktur in einem bestimmten Teil eines Gebäudes, dann das ganze Gebäude und zum Schluss die Stromversorgung eines Serverraumes.

Die Schutzvorrichtung 1 der verunfallten Person 8, bzw. eine Kommunikationseinheit 80 der Schutzvorrichtung 1 oder auch ein damit gekoppeltes externes Gerät 71, beispielsweise ein Mobiltelefon das die Person 8 mitführt, kann auch mit lautem akustischen Signal, optional auch mit gesprochenem Warntext, umgebende, eventuell auch ungeschulte und nicht ausgerüstete, weitere Personen auf die Gefahr und die benötigte Hilfe aufmerksam machen. Eine akustische Warnung wie "Achtung - Stromunfall - diese Person steht unter Spannung. Person nicht anfassen. Stromkreis unterbrechen oder Person vom Stromkreis wegrempeln" oder "Achtung - Stromunfall - diese Person hat einen elektrischen Schlag bekommen. Berührbare Teile unter Spannung sind in der Nähe" wäre beispielsweise denkbar.

Im Falle einer Funkverbindung zur Übermittlung des Ausgabesignals S von der Schutzvorrichtung 1 an einen Funkempfänger 90 der elektrischen Anlage 10, kann natürlich überprüft werden, entweder laufend oder zumindest zu Beginn der Arbeiten, ob überhaupt eine Funkverbindung besteht. Falls nicht, kann an der Schutzvorrichtung 1 ein entsprechender Alarm angezeigt werden, beispielsweise akustisch, visuell oder palpabel. Das gleiche gilt natürlich, wenn in der Schutzvorrichtung 1 ein niedriger Ladezustand einer Energieversorgung der Schutzvorrichtung 1 festgestellt wird.

In gewissen Anwendungen, insbesondere in Gebäuden kann die Funkverbindung zwischen der Schutzvorrichtung 1 und dem Funkempfänger zum Empfangen des Notsignals, leicht und unerkannt abreißen, insbesondere wenn sich die Person, die die Schutzvorrichtung 1 trägt, bewegt. Das kann zu Fehlauslösungen führen, wenn ein fehlendes Funksignal im Funkempfänger eine Schalthandlung auslöst. Im schlimmsten Fall besteht für die tragende Person 8 durch die Schutzvorrichtung 1 unbemerkt kein Schutz mehr.

Die elektrische Anlage 10 könnte je nach Gefährlichkeit der Anwendung auch unterschiedlich konfiguriert werden, so dass eine Unterbrechung der Funkverbindung bei sehr gefährlicher Anwendung einen Ausschaltvorgang erzwingt, und bei weniger kritischen Anwendung dies nicht tut.

Abgesehen davon können im Arbeitsbereich der Person 8 räumlich verteilt zumindest zwei Funkempfänger 90a, 90b mit jeweils einem Notsignaleingang 21 zum Empfangen eines Notsignals S von der Schutzvorrichtung 1 vorgesehen sein, wie in Fig.8 dargestellt. Ein Funkempfänger 90a, 90b kann dabei wie oben beschrieben mit der elektrischen Anlage 10 oder dem Gerät 11 der elektrischen Anlage 10 verwendet werden, um ein Notsignal S von der Schutzvorrichtung 1 zu erfassen und eine Handlung auszulösen, insbesondere eine Schalthandlung. In diesem Fall wäre der Notsignaleingang 21 extern von der elektrischen Anlage 10 oder dem Gerät 11 angeordnet und die elektrische Anlage 10 oder das Gerät 11 wäre mit dem externen Notsignaleingang 21 am Funkempfänger 90a, 90b verbunden. Die Schutzvorrichtung 1 steht in bidirektionaler Funkverbindung mit den Funkempfängern 90a, 90b. Das bedeutet, dass an der Schutzvorrichtung 1 ein Signalempfänger 91 vorgesehen sein muss, um ein Funksignal F, das von einem Sender 92a, 92b im Funkempfänger 90a, 90b ausgestrahlt wird, empfangen zu können. Der Signalempfänger 91 ist vorzugsweise am Bekleidungsstück 2 angeordnet oder in das Bekleidungsstück 2 integriert und mit der Auswerteeinheit 6, oder einer anderen Recheneinheit in der Schutzvorrichtung 1, verbunden. Das Funksignal F von einem Funkempfänger 90a, 90b wird dauernd oder zumindest in regelmäßigen Abständen ausgestrahlt, und wird vom Signalempfänger 91 der Schutzvorrichtung 1 empfangen. Die Schutzvorrichtung 1 ist damit in der Lage die Signalqualität des Funkkanals zwischen der Schutzvorrichtung 1 und einem Funkempfänger 90a, 90b auszuwerten. Damit kann die Schutzvorrichtung 1 entscheiden, über welchen der verfügbaren Funkkanäle das Notsignal S gesendet wird.

In einem Gebäude oder eine Anlage können verteilt eine Vielzahl solcher Funkempfänger 90a, 90b angeordnet sein und die Schutzvorrichtung 1 wählt jeweils einen Funkempfänger 90a, 90b aus, beispielsweise den Funkkanal mit der besten Signalqualität, um darüber das Notsignal S zu senden. Auf diese Weise kann sich die Person 8, die die Schutzvorrichtung 1 trägt, ohne Verlust der Funkverbindung durch das Gebäude oder die Anlage bewegen.

Für die Erfindung ist es aber prinzipiell unerheblich wo die Entscheidung getroffen wird über welchen Funkempfänger 90a, 90b kommuniziert werden soll. Die Entscheidung könnte im Signalempfänger 91, in den Funkempfängern 90a, 90b oder in der elektrischen Anlage 10 oder dem Gerät 11 oder auch anderswo getroffen werden.

## Patentansprüche

1. Anordnung mit erhöhter Sicherheit für eine an einer elektrischen Anlage (10) arbeitende Person (8a) bei einem Stromunfall, wobei die Person (8a) eine Schutzvorrichtung (1a) zum Erkennen eines elektrischen Körperstroms durch die Person (8a) trägt und sich im Umfeld der verunfallten Person (8a) zumindest eine weitere Person (8b) mit einer Schutzvorrichtung (1b) oder einem externen Kommunikationsgerät (83b) befindet, **dadurch gekennzeichnet, dass** an der Schutzvorrichtung (1a) der verunfallten Person (8a) eine Kommunikationseinheit (80a) vorgesehen ist, **dass** die Schutzvorrichtung (1a) der verunfallten Person (8a) zumindest im Falle eines Stromunfalles mit einem mit der Schutzvorrichtung (1a) detektierten unzulässigen Körperstrom eine Kommunikationsverbindung (81) zwischen der Kommunikationseinheit (80a) der Schutzvorrichtung (1a) der verunfallten Person (8a) und der Schutzvorrichtung (1b) der weiteren Person (8b) oder zwischen der Kommunikationseinheit (80a) der Schutzvorrichtung (1a) der verunfallten Person (8a) und dem externen Kommunikationsgerät (83b) der weiteren Person (8b) aufbaut **und dass** die Schutzvorrichtung (1a) der verunfallten Person (8a) die zumindest eine weitere Person (8b) über die Kommunikationsverbindung (81) vom Stromunfall informiert.

2. Anordnung nach Anspruch 1, **dadurch gekennzeichnet, dass** an der Schutzvorrichtung (1b) der weiteren Person (8b) eine Kommunikationseinheit (80b) vorgesehen ist und die Kommunikationsverbindung (81) zwischen den beiden Kommunikationseinheiten (80a, 80b) aufgebaut ist.

3. Anordnung nach Anspruch 1, **dadurch gekennzeichnet, dass** die Schutzvorrichtung (1a) der verunfallten Person (8a) die Kommunikationsverbindung (81) über ein externes Kommunikationsgerät (83a) der verunfallten Person (8a) aufbaut.

4. Anordnung nach einem der Ansprüche 1 bis 3, **dadurch gekennzeichnet, dass** die Kommunikationsverbindung (81) über eine Kommunikationszentrale (82) aufgebaut ist.

5. Anordnung nach einem der Ansprüche 1 bis 4, **dadurch gekennzeichnet, dass** an einer Schutzvorrichtung (1a, 1b) eine Sendeeinheit (64), vorzugsweise ein Mobilfunksender (63), angeordnet ist, die im Falle eines detektierten Körperstroms eine Funkverbindung (62) zu einer vorgegebenen entfernten Stelle (60) aufbaut oder an einer Schutzvorrichtung (1a, 1b) eine Sendeeinheit (64), vorzugsweise ein Mobilfunksender (63), angeordnet ist, die im Falle eines detektierten Körperstroms eine Funkverbindung (62) zu einer vorgegebenen entfernten Stelle (60) aufbaut und die Sendeeinheit (64) eine Datenverbindung (65) mit einem mobilen Endgerät (66) der die Schutzvorrichtung (1a, 1b) tragenden Person (8) herstellt und das mobile Endgerät (66) die Funkverbindung (62) zur entfernten Stelle (60) aufbaut, um die entfernte Stelle (60) vom Stromunfall zu informieren.

6. Anordnung nach einem der Ansprüche 1 bis 5, **dadurch gekennzeichnet, dass** eine Schutzvorrichtung (1a, 1b) ein Bekleidungsstück (2) und eine Auswerteeinheit (6) umfasst, wobei die Person (8a, 8b) das Bekleidungsstück (2) trägt und das Bekleidungsstück (2) mit zumindest einem Sensor (3) zum Detektieren des Körperstromes ausgestattet ist, und die Auswerteeinheit (6) ein mit dem zumindest einen Sensor (3) erfasstes Signal auswertet.

7. Anordnung nach einem der Ansprüche 1 bis 6, **dadurch gekennzeichnet, dass** die Schutzvorrichtung (1a, 1b) im Falle eines erkannten unzulässigen Körperstromes ein Notsignal (S) ausgibt und an der elektrischen Anlage (10) ein Notsignaleingang (21) vorgesehen ist, der das Notsignal (S) empfängt und bei Empfang des Notsignals (S) die elektrische Anlage (10) oder einen Teil davon spannungsfrei schaltet.

8. Anordnung nach einem der Ansprüche 1 bis 7, **dadurch gekennzeichnet, dass** die Schutzvorrichtung (1a) zumindest einen weiteren Sensor (9) umfasst, der einen weiteren Zustand der die Schutzvorrichtung (1a) tragenden Person (8a) erfasst und/oder eine Einheit (72) zur Positionsbestimmung oder der Ortsbestimmung der Person (8a), vorzugsweise ein mobiles Endgerät (66a) der Person, umfasst.

9. Verfahren zur Erhöhung der Sicherheit für eine an einer elektrischen Anlage (10) arbeitende Person (8a) bei einem Stromunfall, wobei die Person (8a) eine Schutzvorrichtung (1a) zum Erkennen eines elektrischen Körperstroms durch die Person (8a) trägt und sich im Umfeld der verunfallten Person (8a) zumindest eine weitere Person (8b) mit einer Schutzvorrichtung (1b) oder einem externen Kommunikationsgerät (83b) befindet, **dadurch gekennzeichnet, dass** die Schutzvorrichtung (1a) der verunfallten Person (8a) über eine Kommunikationseinheit (80a) zumindest im Falle eines Stromunfalles mit einem mit der Schutzvorrichtung (1a) detektierten unzulässigen Körperstrom eine Kommunikationsverbindung (81) zwischen der Kommunikationseinheit (80a) der Schutzvorrichtung (1a) der verunfallten Person (8a) und der Schutzvorrichtung (1b) der weiteren Person (8b) oder zwischen der Kommunikationseinheit (80a) der Schutzvorrichtung (1a) der verunfallten Person (8a) und dem externen Kommunikationsgerät (83b) der weiteren Person (8b) aufbaut **und dass** die Schutzvorrichtung (1a) der verunfallten Person (8a) die zumindest eine weitere Person (8b) über die Kommunikationsverbindung (81) vom Stromunfall informiert.

10. Verfahren nach Anspruch 9, **dadurch gekennzeichnet, dass** die Kommunikationsverbindung (81) zwischen der Kommunikationseinheit (80a) an der Schutzvorrichtung (1a) der verunfallten Person (8a) und einer Kommunikationseinheit (80b) an der Schutzvorrichtung (1b) der weiteren Person (8b) aufgebaut wird.

11. Verfahren nach Anspruch 9, **dadurch gekennzeichnet, dass** die Schutzvorrichtung (1a) der verunfallten Person (8a) die Kommunikationsverbindung (81) über ein externes Kommunikationsgerät (83a) der verunfallten Person (8a) aufbaut.

12. Verfahren nach einem der Ansprüche 9 bis 11, **dadurch gekennzeichnet, dass** die Kommunikationsverbindung (81) über eine Kommunikationszentrale (82) aufgebaut wird.

13. Verfahren nach einem der Ansprüche 9 bis 12, **dadurch gekennzeichnet, dass** eine Schutzvorrichtung (1a, 1b) im Falle eines Stromunfalls über eine Sendeeinheit (64) eine Funkverbindung (62) zu einer vorgegebenen entfernten Stelle (60) aufbaut oder eine Schutzvorrichtung (1a, 1b) im Falle eines Stromunfalls über eine Sendeeinheit (64) eine Funkverbindung (62) zu einer vorgegebenen entfernten Stelle (60) aufbaut und die Sendeeinheit (64) eine Datenverbindung (65) mit einem mobilen Endgerät (66) der die Schutzvorrichtung tragenden Person (1a, 1b) herstellt und das mobile Endgerät (66) die Funkverbindung (62) zur entfernten Stelle (60) aufbaut, um die entfernte Stelle (60) vom Stromunfall zu informieren.

14. Verfahren nach Anspruch 13, **dadurch gekennzeichnet, dass** die Schutzvorrichtung (1a, 1b) der entfernten Stelle (60) auch Daten zumindest eines weiteren Sensors (9) der Schutzvorrichtung (1a) der verunfallten Person (8a) und/oder die Position oder den Ort der verunfallten Person (8a) übermittelt.

15. Verfahren nach einem der Ansprüche 9 bis 14, **dadurch gekennzeichnet, dass** die die Schutzvorrichtung (1a) der verunfallten Person (8a) im Falle eines erkannten unzulässigen Körperstromes ein Notsignal (S) ausgibt, das in der elektrischen Anlage (10) an einem Notsignaleingang (21) empfangen wird und bei Empfang des Notsignals (S) die elektrische Anlage (10), oder ein Teil davon, spannungsfrei geschaltet wird.

## Claims

1. System with increased safety for a person (8a) working on an electrical system (10) in the event of an electrical accident, wherein the person (8a) wears a protective device (1a) for detecting an electrical current flowing through the person (8a) and wherein at least one further person (8b) with a protective device (1b) or an external communication device (83b) is in the vicinity of the person (8a) having the accident, **characterized in that** a communication unit (80a) is provided on the protective device (1a) of the person (8a) having the accident, **that** the protective device (1a) of the person (8a) having the accident, at least in the event of an electrical accident with an unacceptable body current detected with the protective device (1a), establishes a communication link (81) between the communication unit (80a) of the protective device (1a) of the person (8a) having the accident and the protective device (1b) of the further person (8b) or between the communication unit (80a) of the protective device (1a) of the person (8a) having the accident and the external communication device (83b) of the further person (8b) **and that** the protective device (1a) of the person (8a) having the accident informs the at least one further person (8b) of the electrical accident via the communication link (81).

2. System according to claim 1, **characterized in that** a communication unit (80b) is provided on the protective device (1b) of the further person (8b) and that the communication link (81) is established between the two communication units (80a, 80b).

3. System according to claim 1, **characterized in that** the protective device (1a) of the person (8a) having the accident sets up the communication link (81) via an external communication device (83a) of the person (8a) having the accident.

4. System according to any of the claims 1 to 3, **characterized in that** the communication link (81) is established via a communication center (82).

5. System according to any of the claims 1 to 4, **characterized in that** a transmitting unit (64), preferably a mobile radio transmitter (63), is arranged on a protective device (1a, 1b) which, in the event a body current is detected, establishes a radio link (62) to a predetermined remote location (60) or a transmitting unit (64), preferably a mobile radio transmitter (63), is arranged on a protective device (1a, 1b) which, in the event a body current is detected, establishes a radio link (62) to a predetermined remote location (60) to inform the remote location (60) of the electrical accident and the transmitting unit (64) establishes a data connection (65) with a mobile terminal (66) of the person (8) wearing the protective device (1a, 1b) and that the mobile terminal (66) establishes the radio link (62) to the remote location (60), to inform the remote location (60) of the electrical accident.

6. System according to any of the claims 1 to 5, **characterized in that** a protective device (1a, 1b) comprises an item of clothing (2) and an evaluation unit (6), wherein the person (8a, 8b) wears the item of clothing (2) and that the item of clothing (2) is equipped with at least one sensor (3) to detect the body current, and that the evaluation unit (6) evaluates a signal detected by the at least one sensor (3).

7. System according to any of the claims 1 to 6, **characterized in that** the protective device (1a, 1b) outputs an emergency signal (S) in the event of a detected unacceptable body current and an emergency signal input (21) is provided on the electrical system (10), which receives the emergency signal (S) and switches the electrical system (10) or part of it off when the emergency signal (S) is received.

8. System according to any of the claims 1 to 7, **characterized in that** the protective device (1a) comprises at least one further sensor (9) which detects a further condition of the person (8a) wearing the protective device (1a) and/or a unit (72) for determining the position or location of the person (8a), preferably a mobile terminal (66a) of the person.

9. Method to increase the safety for a person (8a) working on an electrical system (10) in the event of an electrical accident, wherein the person (8a) wears a protective device (1a) for detecting an electrical current flowing through the person (8a) and wherein at least one further person (8b) with a protective device (1b) or an external communication device (83b) is in the vicinity of the person (8a) having the accident, **characterized in that** the protective device (1a) of the person (8a) having the accident establishes via a communication unit (80a), at least in the event of an electrical accident with an unacceptable body current detected with the protective device (1a), a communication link (81) between the communication unit (80a) of the protective device (1a) of the person (8a) having the accident and the protective device (1b) of the further person (8b) or between the communication unit (80a) of the protective device (1a) of the person (8a) having the accident and the external communication device (83b) of the further person (8b) **and that** the protective device (1a) of person (8a) having the accident informs the at least one further person (8b) of the electrical accident via the communication link (81).

10. Method according to claim 9, **characterized in that** the communication link (81) is established between the communication unit (80a) on the protective device (1a) of the person (8a) having the accident and a communication unit (80b) on the protective device (1b) of the further person (8b).

11. Method according to claim 9, **characterized in that** the protective device (1a) of the person (8a) having the accident establishes the communication link (81) via an external communication device (83a) of the person (8a) having the accident.

12. Method according to any of the claims 9 to 11, **characterized in that** the communication link (81) is established via a communication center (82).

13. Method according to any of claims 9 to 12, **characterized in that** in the event of an electrical accident a protective device (1a, 1b) establishes a radio link (62) via a transmitter unit (64) to a predetermined remote location (60) or in the event of an electrical accident a protective device (1a, 1b) establishes a radio link (62) via a transmitter unit (64) to a predetermined remote location (60) and the transmitting unit (64) establishes a data connection (65) with a mobile terminal (66) of the person (1a, 1b) wearing the protective device and that the mobile terminal (66) establishes the radio link (62) to the remote location (60), in order to inform the remote location (60) of the electrical accident.

14. Method according to claim 13, **characterized in that** the protective device (1a, 1b) also transmits data from at least one further sensor (9) of the protective device (1a) of the person (8a) having the accident and/or the position or location of the accident victim (8a) to the remote location (60).

15. Method according to any of the claims 9 to 14, **characterized in that** the protective device (1a) of the person (8a) having the accident outputs an emergency signal (S) in the event of a recognized unacceptable body current, which is received in the electrical system (10) at an emergency signal input (21), and the electrical system (10) or part of the system is switched off in the event that an emergency signal (S) is received.

## Revendications

1. Agencement à sécurité accrue pour personne (8a) travaillant sur un système électrique (10) en cas d'accident électrique, la personne (8a) portant un dispositif de protection (1a) permettant de détecter un courant de choc électrique traversant la personne (8a) et au moins une autre personne (8b) avec un dispositif de protection (1b) ou un appareil de communication externe (83b) se trouvant à proximité de la personne (8a) impliquée dans un accident, **caractérisé en ce qu'**une unité de communication (80a) est prévue sur le dispositif de protection (1a) de la personne (8a) impliquée dans un accident, **en ce que** le dispositif de protection (1a) de la personne (8a) impliquée dans un accident établit une liaison de communication (81) entre l'unité de communication (80a) du dispositif de protection (1a) de la personne (8a) impliquée dans un accident et le dispositif de protection (1b) de l'autre personne (8b), ou entre l'unité de communication (80a) du dispositif de protection (1a) de la personne (8a) impliquée dans un accident et l'appareil de communication externe (83b) de l'autre personne (8b), au moins en cas d'accident électrique avec un courant de choc inadmissible détecté par le dispositif de protection (1a), **et en ce que** le dispositif de protection (1a) de la personne (8a) impliquée dans un accident informe l'au moins une autre personne (8b) de l'accident électrique par l'intermédiaire de la liaison de communication (81).

2. Agencement selon la revendication 1, **caractérisé en ce qu'**une unité de communication (80b) est prévue sur le dispositif de protection (1b) de l'autre personne (8b) et la liaison de communication (81) est établie entre les deux unités de communication (80a, 80b).

3. Agencement selon la revendication 1, **caractérisé en ce que** le dispositif de protection (1a) de la personne (8a) impliquée dans un accident établit la liaison de communication (81) par l'intermédiaire d'un appareil de communication externe (83a) de la personne (8a) impliquée dans un accident.

4. Agencement selon l'une des revendications 1 à 3, **caractérisé en ce que** la liaison de communication (81) est établie par l'intermédiaire d'un centre de communication (82).

5. Agencement selon l'une des revendications 1 à 4, **caractérisé en ce qu'**une unité d'émission (64), de préférence un émetteur radio mobile (63), est disposée sur un dispositif de protection (1a, 1b) et, en cas de détection d'un courant de choc, établit une liaison radio (62) vers un poste distant (60) prédéfini ou une unité d'émission (64), de préférence un émetteur radio mobile (63), est disposée sur un dispositif de protection (1a, 1b) et, en cas de détection d'un courant de choc, établit une liaison radio (62) vers un poste distant (60) prédéfini et l'unité d'émission (64) met en place une liaison de données (65) avec un terminal mobile (66) de la personne (8) portant le dispositif de protection (1a, 1b) et le terminal mobile (66) établit la liaison radio (62) avec le poste distant (60) pour informer le poste distant (60) de l'accident électrique.

6. Agencement selon l'une des revendications 1 à 5, **caractérisé en ce qu'**un dispositif de protection (1a, 1b) comprend un vêtement (2) et une unité d'évaluation (6), la personne (8a, 8b) portant le vêtement (2) et le vêtement (2) étant équipé d'au moins un capteur (3) permettant de détecter le courant de choc, et l'unité d'évaluation (6) évaluant un signal détecté par l'au moins un capteur (3).

7. Agencement selon l'une des revendications 1 à 6, **caractérisé en ce que** le dispositif de protection (1a, 1b) émet un signal d'urgence (S) en cas de détection d'un courant de choc inadmissible et une entrée de signal d'urgence (21) est prévue sur le système électrique (10), laquelle reçoit le signal d'urgence (S) et, lorsque le signal d'urgence (S) est reçu, le système électrique (10) ou une partie de celui-ci est mis hors tension.

8. Agencement selon l'une des revendications 1 à 7, **caractérisé en ce que** le dispositif de protection (1a) comprend au moins un autre capteur (9) qui détecte un autre état de la personne (8a) portant le dispositif de protection (1a) et/ou une unité (72) permettant de déterminer la position ou l'emplacement de la personne (8a), de préférence un terminal mobile (66a) de la personne.

9. Procédé permettant d'augmenter la sécurité pour une personne (8a) travaillant sur un système électrique (10) en cas d'accident électrique, la personne (8a) portant un dispositif de protection (1a) permettant de détecter un courant de choc électrique traversant la personne (8a) et au moins une autre personne (8b) avec un dispositif de protection (1b) ou un appareil de communication externe (83b) se trouvant à proximité de la personne (8a) impliquée dans un accident, **caractérisé en ce que** le dispositif de protection (1a) de la personne (8a) impliqué dans un accident établit une liaison de communication (81) entre l'unité de communication (80a) du dispositif de protection (1a) de la personne (8a) impliquée dans un accident et le dispositif de protection (1b) de l'autre personne (8b) ou entre l'unité de communication (80a) du dispositif de protection (1a) de la personne (8a) impliquée dans un accident et l'appareil de communication externe (83b) de l'autre personne (8b) par l'intermédiaire d'une unité de communication (80a), au moins en cas d'accident électrique avec un courant de choc inadmissible détecté avec le dispositif de protection (1a), **et en ce que** le dispositif de protection (1a) de la personne (8a) impliquée dans un accident informe l'au moins une autre personne (8b) de l'accident électrique par l'intermédiaire de la liaison de communication (81).

10. Procédé selon la revendication 9, **caractérisé en ce que** la liaison de communication (81) entre l'unité de communication (80a) sur le dispositif de protection (1a) de la personne (8a) impliquée dans un accident et une unité de communication (80b) sur le dispositif de protection (1b) de l'autre personne (8b) est établie.

11. Procédé selon la revendication 9, **caractérisé en ce que** le dispositif de protection (1a) de la personne (8a) impliquée dans un accident établit la liaison de communication (81) par l'intermédiaire d'un appareil de communication externe (83a) de la personne (8a) impliquée dans un accident.

12. Procédé selon l'une des revendications 9 à 11, **caractérisé en ce que** la liaison de communication (81) est établie par l'intermédiaire d'un centre de communication (82).

13. Procédé selon l'une des revendications 9 à 12, **caractérisé en ce qu'**un dispositif de protection (1a, 1b) établit une liaison radio (62) vers un poste distant (60) prédéfini par l'intermédiaire d'une unité d'émission (64) en cas d'accident électrique, ou un dispositif de protection (1a, 1b) établit une liaison radio (62) vers un poste distant (60) prédéfini par l'intermédiaire d'une unité d'émission (64) en cas d'accident électrique et l'unité d'émission (64) met en place une liaison de données (65) avec un terminal mobile (66) de la personne (1a, 1b) portant le dispositif de protection et le terminal mobile (66) établit la liaison radio (62) avec le poste distant (60) pour informer le poste distant (60) de l'accident électrique.

14. Procédé selon la revendication 13, **caractérisé en ce que** le dispositif de protection (1a, 1b) transmet également des données d'au moins un autre capteur (9) du dispositif de protection (1a) de la personne (8a) impliquée dans un accident et/ou la position ou l'emplacement de la personne (8a) impliquée dans un accident au poste distant (60).

15. Procédé selon l'une des revendications 9 à 14, **caractérisé en ce que** le dispositif de protection (1a) de la personne (8a) impliquée dans un accident émet un signal d'urgence (S), en cas de détection d'un courant de choc inadmissible, qui est reçu dans le système électrique (10) au niveau d'une entrée de signal d'urgence (21) et, lorsque le signal d'urgence (S) est reçu, le système électrique (10), ou une partie de celui-ci, est mis hors tension.
